# EUROPEAN PATENT APPLICATION

(11) **EP 3 032 574 A1**
(43) Date of publication of application: **15.06.2016**
(21) Application number: 14834945.9
(22) Date of filing: 25.06.2014
(51) Int. Cl.: H01L 21/20, H01L 21/02, H01L 21/205, H01L 21/265, H01L 21/336, H01L 29/06, H01L 29/12, H01L 29/78

(54) **SILICON CARBIDE SEMICONDUCTOR SUBSTRATE, METHOD FOR PRODUCING SAME, AND METHOD FOR PRODUCING SILICON CARBIDE SEMICONDUCTOR DEVICE**

(30) Priority: 06.08.2013 JP 2013163408
(71) Applicant: Sumitomo Electric Industries, Ltd., Osaka-shi, Osaka 541-0041 (JP)
(72) Inventor: HORII, Taku, Osaka-shi Osaka 554-0024 (JP); MASUDA, Takeyoshi, Osaka-shi Osaka 554-0024 (JP)
(74) Representative: Grünecker Patent- und Rechtsanwälte PartG mbB
(86) International application number: PCT/JP2014/066822
(87) International publication number: WO 2015/019734

(57) **Abstract**

A silicon carbide semiconductor substrate (10) includes: a base substrate (1) that has a main surface (1A) having an outer diameter of not less than 100 mm and that is made of single-crystal silicon carbide; and an epitaxial layer (2) formed on the main surface (1A), a groove (9) being formed in a main surface (2A) of the epitaxial layer (2) or a backside surface (1B) of the base substrate (1) opposite to the main surface (1A) of the base substrate (1). In this way, the groove (9) suppresses the substrate from being deformed (warped during a high temperature treatment, for example). This can reduce a risk of causing defects such as crack in the silicon carbide semiconductor substrate (10) during the manufacturing process in performing a method for manufacturing a silicon carbide semiconductor device using the silicon carbide semiconductor substrate (10)

## Description

### TECHNICAL FIELD

The present invention relates to a silicon carbide semiconductor substrate, a method for manufacturing the silicon carbide semiconductor substrate, and a method for manufacturing a silicon carbide semiconductor device, in particular, a silicon carbide semiconductor substrate having a high degree of flatness even when thermally treated at a high temperature, a method for manufacturing the silicon carbide semiconductor substrate, and a method for manufacturing a silicon carbide semiconductor device.

### BACKGROUND ART

In recent years, silicon carbide (SiC) crystals have been adopted as semiconductor substrates for use in manufacturing semiconductor devices. SiC has a band gap larger than that of silicon (Si), which has been used more commonly. Hence, a semiconductor device employing SiC advantageously has a high breakdown voltage, low on resistance, and properties less likely to decrease in a high temperature environment.

Further, in order to manufacture silicon carbide semiconductor devices efficiently, silicon carbide semiconductor substrates have begun to be provided with a larger diameter. However, when a silicon carbide semiconductor substrate is provided with an outer diameter of, for example, about 6 inches, the silicon carbide semiconductor substrate becomes less flat.

Japanese Patent Laying-Open No. 2012-214376 describes a SiC wafer having a diameter of at least about 75 millimeters (3 inches), a distortion of less than about 5 µm, a warpage of less than about 5 mm, and a TTV of less than about 2.0 µm. Specifically, it is described that a SiC boule is sliced thinly into a form of wafer, and the thinly sliced it is described that a SiC boule is sliced thinly into a form of wafer, and the thinly sliced wafer is placed on a double-sided lapper to start a lapping process using downward force smaller than downward force necessary to bend the wafer, thereby producing a wafer having low distortion, warpage, and TTV.

### CITATION LIST

### PATENT DOCUMENT

PTD 1: Japanese Patent Laying-Open No 2012-214376

### SUMMARY OF INVENTION

### TECHNICAL PROBLEM

However, it is confirmed that some silicon carbide semiconductor substrates have a low degree of flatness due to a high-temperature heat treatment even if the silicon carbide semiconductor substrates have had warpage and TTV each falling within the range described in Japanese Patent Laying-Open No 2012-214376 under a room temperature. For example, generally in a method for manufacturing a silicon carbide semiconductor device, doping is performed by way of ion implantation under a high temperature; however, it is difficult to suction a silicon carbide semiconductor substrate having a low degree of flatness onto an electrostatic chuck stage of the implantation device, and in some cases, it has been confirmed that substrates become broken, disadvantageously.

Moreover, ion implantation into such a silicon carbide semiconductor substrate having a low degree of flatness causes formation of the following regions: a region having a surface perpendicular to the ion implantation direction, and a region having a surface not perpendicular to the ion implantation direction and inclined relative to the ion implantation direction. This leads to variation in the shapes of impurity regions formed in the silicon carbide semiconductor substrates.

Moreover, such a low degree of flatness caused under a high temperature is a particularly serious problem in a silicon carbide semiconductor substrate having a large diameter of not less than 100 mm. Specifically, even though a silicon carbide semiconductor substrate having a large diameter (particularly not less than 100 mm) is used to obtain silicon carbide semiconductor devices efficiently, the low degree of flatness caused as described above makes it difficult to produce silicon carbide semiconductor devices with good yield.

The present invention has been made to solve the above problem. The present invention has a main object to provide a silicon carbide semiconductor substrate having a high degree of flatness even under a high temperature, a method for manufacturing the silicon carbide semiconductor substrate, and a method for manufacturing a silicon carbide semiconductor device. Another object is to provide a method for manufacturing a silicon carbide semiconductor device to produce silicon carbide semiconductor devices with good yield using a silicon carbide semiconductor substrate having a large diameter.

### SOLUTION TO PROBLEM

A silicon carbide semiconductor substrate according to the present invention includes: a base substrate that has a main surface having an outer diameter of not less than 100 mm and that is made of single-crystal silicon carbide; and an epitaxial layer formed on the main surface, a groove being formed in at least one of a main surface of the epitaxial layer and a backside surface of the base substrate, the main surface of the epitaxial layer being opposite to a surface of the epitaxial layer facing the base substrate, the backside surface of the base substrate being opposite to the main surface of the base substrate on which the epitaxial layer is formed.

A method for manufacturing a silicon carbide semiconductor substrate according to the present invention includes steps of: preparing a base substrate that has a main surface having an outer diameter of not less than 100 mm and that is made of single-crystal silicon carbide; forming an epitaxial layer on the main surface; and forming a groove in at least one of a main surface of the epitaxial layer and a backside surface of the base substrate, the main surface of the epitaxial layer being opposite to a surface of the epitaxial layer facing the base substrate, the backside surface of the base substrate being opposite to the main surface of the base substrate on which the epitaxial layer is formed.

A method for manufacturing a silicon carbide semiconductor device according to the present invention includes steps of: preparing a base substrate that has a main surface having an outer diameter of not less than 100 mm and that is made of single-crystal silicon carbide; forming an epitaxial layer on the main surface; preparing a silicon carbide semiconductor substrate by forming a groove in at least one of a main surface of the epitaxial layer and a backside surface of the base substrate, the main surface of the epitaxial layer being opposite to a surface of the epitaxial layer facing the base substrate, the backside surface of the base substrate being opposite to the main surface of the base substrate on which the epitaxial layer is formed; and implanting an impurity ion into the silicon carbide semiconductor substrate.

### ADVANTAGEOUS EFFECTS OF INVENTION

According to the present invention, there can be obtained a silicon carbide semiconductor substrate having a high degree of flatness even under a high temperature Moreover, there can be provided a method for manufacturing a silicon carbide semiconductor device to produce silicon carbide semiconductor devices with good yield.

### BRIEF DESCRIPTION OF DRAWINGS

Fig 1 is a schematic view of a silicon carbide semiconductor substrate according to an embodiment.
Fig. 2 is a schematic view for illustrating the definition of an amount of warpage in the silicon carbide semiconductor substrate
Fig 3 is a schematic view for illustrating the definition of the amount of warpage in the silicon carbide semiconductor substrate.
Fig. 4 is a schematic view showing an example of the planar shape of a groove formed in the silicon carbide semiconductor substrate shown in Fig. 1
Fig 5 is a schematic view showing an example of the planar shape of the groove formed in the silicon carbide semiconductor substrate shown in Fig 1.
Fig 6 is a schematic view showing an example of the planar shape of the groove formed in the silicon carbide semiconductor substrate shown in Fig. 1.
Fig. 7 is a schematic view showing an example of the planar shape of the groove formed in the silicon carbide semiconductor substrate shown in Fig. 1.
Fig. 8 is a flowchart of a method for manufacturing the silicon carbide semiconductor substrate according to the embodiment.
Fig 9 illustrates the method for manufacturing the silicon carbide semiconductor device according to the embodiment.
Fig. 10 illustrates the method for manufacturing the silicon carbide semiconductor device according to the embodiment
Fig. 11 illustrates the method for manufacturing the silicon carbide semiconductor device according to the embodiment.
Fig. 12 is a schematic view of a modification of the silicon carbide semiconductor substrate according to the embodiment Fig 13 is an enlarged schematic plan view of a region XIII in Fig. 12.
Fig. 14 is a schematic view of a silicon carbide semiconductor device according to the embodiment.
Fig. 15 is a flowchart of a method for manufacturing the silicon carbide semiconductor device according to the embodiment.
Fig 16 illustrates function and effect of the method for manufacturing the silicon carbide semiconductor device according to the embodiment.
Fig. 17 illustrates function and effect of the method for manufacturing the silicon carbide semiconductor device according to the embodiment.
Fig 18 is a reference diagram for illustrating function and effect of the method for manufacturing the silicon carbide semiconductor device according to the embodiment
Fig 19 is a reference diagram for illustrating function and effect of the method for manufacturing the silicon carbide semiconductor device according to the embodiment

### DESCRIPTION OF EMBODIMENTS

The following describes an embodiment of the present invention with reference to figures. It should be noted that in the below-mentioned figures, the same or corresponding portions are given the same reference characters and are not described repeatedly. Regarding crystallographic indications in the present specification, an individual orientation is represented by [], a group orientation is represented by <>, and an individual plane is represented by (), and a group plane is represented by {}. In addition, a negative crystallographic index is normally expressed by putting "-" (bar) above a numeral, but is expressed by putting the negative sign before the numeral in the present specification.

### [Description of Embodiment of the Invention of the Present Application]

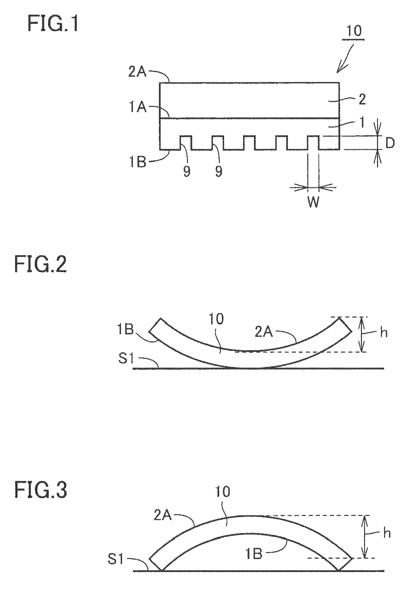

First, overview of an embodiment of the present invention is listed.
(1) With reference to Fig. 1, a silicon carbide semiconductor substrate 10 according to the present embodiment includes: a base substrate 1 that has a main surface 1A having an outer diameter of not less than 100 mm and that is made of single-crystal silicon carbide; and an epitaxial layer 2 formed on main surface 1A, a groove 9 being formed in at least one of a main surface 2A of epitaxial layer 2 and a backside surface 1B of base substrate 1, main surface 2A of epitaxial layer 2 being opposite to a surface of epitaxial layer 2 facing base substrate 1, backside surface 1B of base substrate 1 being opposite to main surface 1A of base substrate 1 on which epitaxial layer 2 is formed. It should be noted that silicon carbide semiconductor substrate 10 according to the present embodiment is a large-diameter substrate having an outer diameter of not less than 100 mm, preferably not less than 125 mm, and more preferably not less than 150 mm.
   In this way, in silicon carbide semiconductor substrate 10 according to the present embodiment, which is a large-diameter substrate having an outer diameter of not less than 100 mm, groove 9 formed in the main surface of epitaxial layer 2 or backside surface 1B of base substrate 1 relaxes internal stress in the front surface and backside surface of silicon carbide semiconductor substrate 10. As a result, silicon carbide semiconductor substrate 10 is suppressed from being deformed (warped during a high temperature treatment, for example). This can reduce a risk of causing defects such as crack in silicon carbide semiconductor substrate 10 during the manufacturing process in performing a method for manufacturing a silicon carbide semiconductor device using silicon carbide semiconductor substrate 10.
   Specifically, discussion is now directed to, for example, a case where in the method for manufacturing the silicon carbide semiconductor device, doping is performed by means of ion implantation into silicon carbide semiconductor substrate 10 under a high temperature and where silicon carbide semiconductor substrate 10 is suctioned using an electrostatic chuck stage of an ion implantation apparatus. In this case, by appropriately selecting the configuration (such as planar shape such as width and position, and depth of groove 9) of groove 9 serving as a stress relaxation groove, the amount of warpage of silicon carbide semiconductor substrate 10 at a high temperature (for example, 400°C) can be sufficiently small. Accordingly, no strong stress is applied to silicon carbide semiconductor substrate 10 by suctioning This can reduce a risk of causing defects such as breakage and crack in silicon carbide semiconductor substrate 10
   Further, silicon carbide semiconductor substrate 10 according to the present embodiment is a large-diameter substrate having an outer diameter of not less than 100 mm, and provides excellent flatness as described above, with the result that silicon carbide semiconductor devices having small variation in characteristics can be produced on silicon carbide semiconductor substrate 10 when performing the process of manufacturing silicon carbide semiconductor devices using silicon carbide semiconductor substrate 10. Specifically, discussion is now directed to a step of performing a process onto main surface 2A of silicon carbide semiconductor substrate 10 in a specific direction such as ion implantation into silicon carbide semiconductor substrate 10 or the like, for example In this case, the high degree of flatness of main surface 2A of silicon carbide semiconductor substrate 10 can suppress occurrence of such a problem that the position and configuration of the processed region (such as the implantation region) relative to main surface 2A are varied locally in main surface 2A As a result, the variation in process on main surface 2A can be reduced
   Moreover, for exposure with high precision, silicon carbide semiconductor substrate 10 preferably has an LTV (Local Thickness Variation) of not more than 1 µm, for example. In this case, apparent LTV may become large if actual thickness fluctuation of a silicon carbide semiconductor substrate is so small as to be not more than 1 µm but the amount of warpage of the silicon carbide semiconductor substrate is large when the silicon carbide semiconductor substrate is suctioned onto a vacuum chuck stage of an exposure apparatus In contrast, since silicon carbide semiconductor substrate 10 according to the present embodiment can have a small amount of warpage, apparent LTV does not become large, thus allowing for exposure with high precision. As described above, silicon carbide semiconductor devices can be produced with good yield by performing the process of manufacturing silicon carbide semiconductor devices using large-diameter silicon carbide semiconductor substrate 10 having a high degree of flatness.
(2) Preferably in silicon carbide semiconductor substrate 10 according to the present embodiment, silicon carbide semiconductor substrate 10 has an amount of warpage of not less than -100 µm and not more than 100 µm when a substrate temperature is a room temperature, and has an amount of warpage of not less than -1.5 mm and not more than 1.5 mm when the substrate temperature is 400°C. In this case, it is possible to securely reduce a risk of causing defects such as crack in silicon carbide semiconductor substrate 10 during the manufacturing process in performing a method for manufacturing a silicon carbide semiconductor device using silicon carbide semiconductor substrate 10.
   Here, with reference to Fig. 2 and Fig 3, the term "amount of warpage" of silicon carbide semiconductor substrate 10 is intended to indicate a difference between the height of the highest location and the height of the lowest location relative to a plane S1 in main surface 2A of silicon carbide semiconductor substrate 10 when silicon carbide semiconductor substrate 10 is placed on plane S1. Here, with reference to Fig 2, a negative value of the amount of warpage represents a case where main surface 2A of silicon carbide semiconductor substrate 10 projects downward (a case where the central position of silicon carbide semiconductor substrate 10 is lower than the outer circumference position thereof relative to plane S1), whereas with reference to Fig. 3, a positive value of the amount of warpage represents a case where main surface 2A of silicon carbide semiconductor substrate 10 projects upward (a case where the central position of silicon carbide semiconductor substrate 10 is higher than the outer circumference position thereof relative to plane S1). Moreover, the term "substrate temperature" is intended to indicate a temperature measured by a radiation thermometer from the main surface 2A side of silicon carbide semiconductor substrate 10 in a semiconductor manufacturing apparatus such as an ion implantation apparatus, for example.
(3) In silicon carbide semiconductor substrate 10 according to the present embodiment, groove 9 may have any one planar shape selected from a group consisting of a form of stripes, a form of grid, a form of concentric circles, and a form of honeycomb In this case, by appropriately selecting the planar shape of groove 9 as described above, stress is relaxed in the surface of silicon carbide semiconductor substrate 10 (main surface 2A of epitaxial layer 2 or backside surface 1B of base substrate 1), thereby improving flatness of silicon carbide semiconductor substrate 10.
(4) A method for manufacturing a silicon carbide semiconductor substrate 10 according to the present invention includes steps of: preparing (S10) a base substrate 1 that has a main surface 1A having an outer diameter of not less than 100 mm and that is made of single-crystal silicon carbide, forming (S20) an epitaxial layer 2 on the main surface, and forming (S30) a groove 9 in at least one of a main surface 2A of epitaxial layer 2 and a backside surface 1B of base substrate 1, main surface 2A of epitaxial layer 2 being opposite to a surface of epitaxial layer 2 facing base substrate 1, backside surface 1B of base substrate 1 being opposite to main surface 1A of base substrate 1 on which epitaxial layer 2 is formed.
   In this case, discussion is now directed to a case where in the step (S20) of forming epitaxial layer 2, damaged layer 3 is caused at backside surface 1B of base substrate 1 and silicon carbide semiconductor substrate 10 is warped due to an influence of damaged layer 3 In this case, in accordance with a state of warpage, groove 9 is formed in, for example, main surface 2A of epitaxial layer 2 or backside surface 1B of base substrate 1 to relax internal stress, thereby adjusting balance in stress between the front surface side and the backside surface side in silicon carbide semiconductor substrate 10 as a whole. As a result, in accordance with the method for manufacturing the silicon carbide semiconductor substrate according to the present embodiment, silicon carbide semiconductor substrate 10 having a high degree of flatness and an outer diameter of not less than 100 mm can be obtained
(5) In the method for manufacturing silicon carbide semiconductor substrate 10 according to the present embodiment, in the step (S30) of forming the groove, groove 9 may be formed in main surface 2A of epitaxial layer 2 when main surface 2A of epitaxial layer 2 is warped in a form of recess after the step (S20) of forming the epitaxial layer, and the groove is formed in the backside surface when main surface 2A of epitaxial layer 2 is warped in a form of projection after the step (S20) of forming the epitaxial layer.
   In this case, particularly, groove 9 is formed in the surface having compressive stress generated therein (surface deformed in the form of recess) when silicon carbide semiconductor substrate 10 is warped, whereby the region having compressive stress generated therein can be divided by groove 9. As a result, stress can be relaxed in the surface provided with groove 9 as a whole, thereby effectively suppressing the warpage of silicon carbide semiconductor substrate 10.
(6) A method for manufacturing a silicon carbide semiconductor device according to the present embodiment includes steps of: preparing (S10) a base substrate 1 that has a main surface having an outer diameter of not less than 100 mm and that is made of single-crystal silicon carbide; forming (S20) an epitaxial layer 2 on the main surface; preparing (S30) a silicon carbide semiconductor substrate by forming a groove 9 in at least one of a main surface 2A of epitaxial layer 2 and a backside surface 1B of base substrate 1, main surface 2A of epitaxial layer 2 being opposite to a surface of epitaxial layer 2 facing base substrate 1, backside surface 1B of base substrate 1 being opposite to main surface 1A of base substrate 1 on which epitaxial layer 2 is formed; and implanting (S40) an impurity ion into the silicon carbide semiconductor substrate.

That is, in the method for manufacturing the silicon carbide semiconductor device according to the present embodiment, silicon carbide semiconductor substrate 10 obtained by the method for manufacturing the silicon carbide semiconductor substrate according to the present embodiment is used and a silicon carbide semiconductor device is manufactured on silicon carbide semiconductor substrate 10. As described above, silicon carbide semiconductor substrate 10 obtained by the method for manufacturing the silicon carbide semiconductor substrate according to the present embodiment is a substrate having an outer diameter of not less than 100 mm and excellent in flatness with warpage being suppressed. That is, for example, even when heating is performed at a substrate temperature of about 400°C in the step (S40) of implanting an impurity ion into silicon carbide semiconductor substrate 10, silicon carbide semiconductor substrate 10 can be suppressed from being warped and can be maintained to be flat. Hence, an angle formed by the implantation direction of the impurity relative to main surface 2A of silicon carbide semiconductor substrate 10 in the step (S40) can be substantially constant irrespective of an in-plane location in main surface 2A of silicon carbide semiconductor substrate 10 even when the outer diameter of silicon carbide semiconductor substrate 10 is not less than 100 mm. As a result, irrespective of the in-plane location in main surface 2A, the configuration of the ion implantation region (such as the shape of the implantation region or the ion concentration profile in the depth direction of the substrate or the like) can be substantially constant. Therefore, in accordance with the method for manufacturing the silicon carbide semiconductor device according to the present embodiment, silicon carbide semiconductor devices can be produced with good yield

### [Details of Embodiments of the Invention of the Present Application]

Next, details of embodiments of the present invention will be described

### (First Embodiment)

With reference to Fig 1, a silicon carbide semiconductor substrate 10 according to a first embodiment will be described. Silicon carbide semiconductor substrate 10 according to the present embodiment includes a base substrate 1 and an epitaxial layer 2 formed on main surface 1A of base substrate 1, and base substrate 1 has a backside surface 1B opposite to main surface 1A and provided with a groove 9.

Base substrate 1 is made of single-crystal silicon carbide, and has main surface 1A having an outer diameter of 6 inches. Base substrate 1 is made of silicon carbide having, for example, a hexagonal crystal structure and preferably has a crystalline polymorphism (polytype) of 4 H-SiC. Base substrate 1 includes an n type impurity such as nitrogen (N) at a high concentration, and has n type conductivity. Base substrate 1 has an impurity concentration of, for example, about not less than 1.0 × 10¹⁸ cm⁻³ and not more than 1.0 × 10¹⁸ cm⁻³. Main surface 1A may correspond to a {0001} plane, and may correspond to a plane having an off angle of not less than 1° and not more than 10° relative to the {0001} plane, for example Base substrate 1 has a thickness of, for example, about not less than 200 µm and not more than 700 µm, preferably, not less than 300 µm and not more than 600 µm

Epitaxial layer 2 is a layer made of silicon carbide formed on main surface 1A of base substrate 1 by epitaxial growth. Epitaxial layer 2 includes an n type impurity such as nitrogen (N), and epitaxial layer 2 has n type conductivity. The impurity concentration of epitaxial layer 2 may be lower than the impurity concentration of base substrate 1. The impurity concentration of epitaxial layer 2 is about 7.5 × 10¹⁵ cm⁻², for example. Epitaxial layer 2 has a film thickness of about not less than 5 µm and not more than 40 µm, for example.

In silicon carbide semiconductor substrate 10, backside surface 1B of base substrate 1 opposite to main surface 1A is provided with groove 9 as described above. Groove 9 can have depth D and width W of any values For example, depth D of groove 9 can be not less than 1 nm and not more than 100 µm, more preferably, not less than 10 nm and not more than 10 µm. Moreover, width W of groove 9 can be not less than 0.1 µm and not more than 50 mm, more preferably, not less than 1 µm and not more than 1 mm.

A plurality of grooves 9 may be formed in backside surface 1B Moreover, each of grooves 9 may have a rectangular cross sectional shape having a side wall and a bottom wall as shown in Fig. 1; however, a different shape may be employed (such as: a cross sectional shape in which the side wall is inclined relative to backside surface 1B; a V-like shape; a shape in which the bottom wall is curved; or a shape in which both the side wall and the bottom wall are curved)

When the substrate temperature is a room temperature, silicon carbide semiconductor substrate 10 has an amount of warpage of not less than -100 µm and not more than 100 µm, preferably, not less than -40 µm and not more than 40 µm Meanwhile, when the substrate temperature is not less than 100°C and not more than 500°C, silicon carbide semiconductor substrate 10 has an amount of warpage of not less than -1.5 mm and not more than 1.5 mm, preferably, not less than -1.0 mm and not more than 1.0 mm. More preferably, when the substrate temperature is not less than 200°C and not more than 400°C, the amount of warpage is not less than -1.5 mm and not more than 1.5 mm, further preferably, not less than -1.0 mm and not more than 1.0 mm

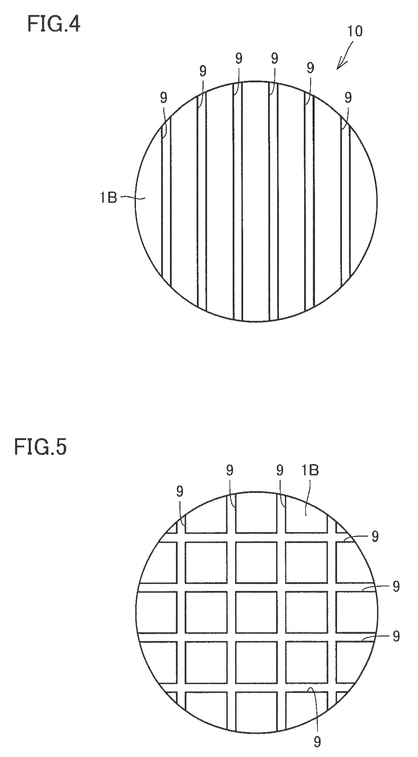

Moreover, groove 9 can have any planar shape. For example, the planar shape of groove 9 may be in the form of stripes in which a plurality of grooves 9 extending in the form of lines as shown in Fig. 4 are arranged side by side with a space interposed therebetween. In Fig. 4, the plurality of grooves 9 are formed to extend substantially in parallel with one another; however, the plurality of grooves 9 do not necessarily need to extend in parallel and a direction in which one groove 9 extends may cross a direction in which another groove 9 extends. Furthermore, a space between adjacent grooves 9 may be substantially constant in the entire backside surface 1B of silicon carbide semiconductor substrate 10; however, the space may be varied locally. For example, the space may be relatively narrow at the central portion of backside surface 1B and may be relatively wide at the outer circumference portion of backside surface 1B. Conversely, the space may be relatively wide at the central portion of backside surface 1B and may be relatively narrow at the outer circumference portion of backside surface 1B. Moreover, groove 9 is formed to extend in the form of a straight line in Fig. 4; however, groove 9 may be formed to have a bent portion or may be formed in the form of a curve. Moreover, grooves 9 may have the same widths W and the same depths D, or grooves 9 may have widths W and depths D of different values.

Moreover, the planar shape of groove 9 may be in the form of grid as shown in Fig. 5. Specifically, a plurality of grooves 9 may be formed to extend in a first direction with a space interposed therebetween, and a plurality of grooves 9 may be formed to extend in a second direction, which is a direction crossing the first direction (preferably, a direction orthogonal to the first direction). A space between adjacent grooves 9 may be the same between the first direction and the second direction or may be different in value between the first direction and the second direction. Moreover, in each of the first direction and the second direction, the space may be varied locally. For example, the space may be relatively narrow at the central portion of backside surface 1B and may be relatively wide at the outer circumference portion of backside surface 1B. Conversely, the space may be relatively wide at the central portion of backside surface 1B and may be relatively narrow at the outer circumference portion of backside surface 1B. Moreover, groove 9 is formed to extend in the form of a straight line in Fig 5; however, groove 9 may be formed to have a bent portion or may be formed in the form of a curve. Moreover, grooves 9 may have the same widths W and the same depths D, or grooves 9 may have widths W and depths D of different values. For example, grooves 9 extending in the first direction may each have width W and depth D of values different from those of grooves 9 extending in the second direction.

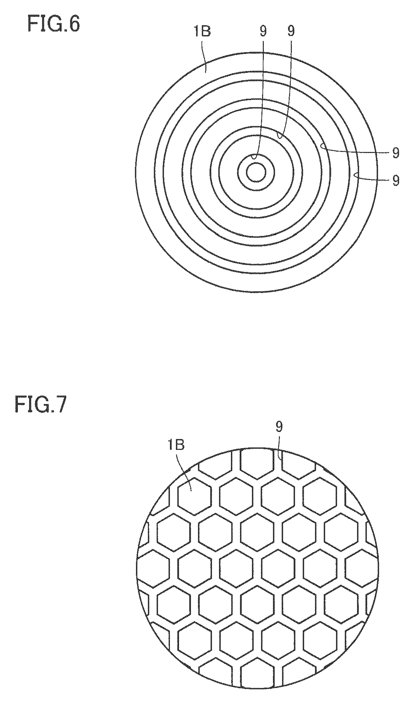

Moreover, the planar shape of groove 9 may be in the form of concentric circles as shown in Fig. 6. Specifically, a plurality of annular grooves 9 may be formed in the form of concentric circles. The plurality of grooves 9 may have the same widths W and the same depths D or may have widths W and depths D of different values. For example, width W may be relatively small at the central side of the concentric circles, and width W may be relatively large at the outer circumference side of the concentric circles. Alternatively, width W may be relatively large at the central side of the concentric circles, and width W may be relatively small at the outer circumference side of the concentric circles. Moreover, depth D may be relatively shallow at the central side of the concentric circles, and depth D may be relatively deep at the outer circumference side of the concentric circles. Alternatively, depth D may be relatively deep at the central side of the concentric circles, and depth D may be relatively shallow at the outer circumference side of the concentric circles.

Moreover, a distance between adjacent grooves 9 may be all the same or the distance may be varied locally For example, the distance may be relatively small at the central side of the concentric circles, and the distance may be relatively large at the outer circumference side of the concentric circles. Alternatively, the distance may be relatively large at the central side of the concentric circles, and the distance may be relatively small at the outer circumference side of the concentric circles.

Moreover, the planar shape of groove 9 may be in the form of honeycomb as shown in Fig 7. Specifically, groove 9 may be formed to provide a plurality of regions each having a polygonal shape (regions each having a hexagonal shape in Fig 7) The sizes of the regions may be substantially uniform in the entire backside surface 1B, but may be varied locally. For example, the size of the region may be relatively small at the central side of backside surface 1B, and the size of the region may be relatively large at the outer circumference side of backside surface 1B. Alternatively, the size of the region may be relatively large at the central side of backside surface 1B, and the size of the region may be relatively small at the outer circumference side of backside surface 1B. Moreover, width W and depth D of groove 9 may be uniform in the entire backside surface 1B, but may be varied locally For example, width W may be relatively small at the central side of backside surface 1 B, and width W may be relatively large at the outer circumference side of backside surface 1B Alternatively, width W may be relatively large at the central side of backside surface 1B, and width W may be relatively small at the outer circumference side of backside surface 1B. Moreover, depth D may be relatively shallow at the central side of backside surface 1B, and depth D may be relatively deep at the outer circumference side of backside surface 1B Alternatively, depth D may be relatively deep at the central side of backside surface 1B, and depth D may be relatively shallow at the outer circumference side of backside surface 1B.

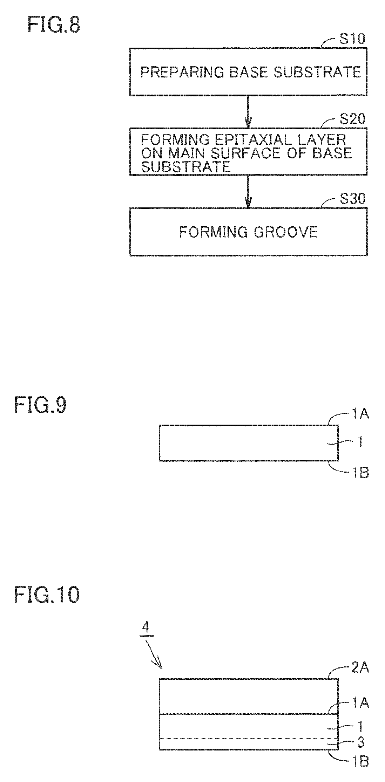

Next, with reference to Fig. 8 to Fig. 11, the following describes a method for manufacturing the silicon carbide semiconductor substrate according to the present embodiment.

With reference to Fig. 8 and Fig 9, first, base substrate 1 is prepared (step (S10)), which has main surface 1 A having an outer diameter of 6 inches and is made of single-crystal silicon carbide. Base substrate 1 having an outer diameter of 6 inches is prepared by any method. It should be noted that the outer diameter of base substrate 1 may be not less than 100 mm (for example, 5 inches, 8 inches, or the like).

Next, with reference to Fig. 10, epitaxial layer 2 is formed on main surface 1A of base substrate 1 by epitaxial growth (step (S20)). The epitaxial growth is performed by a CVD method. As a source material gas, a mixed gas of silane (SiH₄) and propane (C₃H₈) can be used, for example. On this occasion, nitrogen (N) or phosphorus (P) may be introduced as an impurity, for example.

At a point of time after performing this step (S20), silicon (Si) atoms are removed at the whole of or part of backside surface 1B of base substrate 1, which may result in formation of a damaged layer 3 (carbonized layer) including carbon (C) atoms at a relatively high concentration. Damaged layer 3 may be formed to have, for example, a thickness of about not less than 0.001 µm and not more than 10 µm, and can be possibly observed by eyes as whiting in backside surface 1B when damaged layer 3 is formed to have a thickness of not less than 1 µm. In backside surface 1B, a region having damaged layer 3 formed thereon has a surface roughness (Ra) of not less than 0.001 µm At a point of time after performing this step (S20), a stack 4, made up of base substrate 1 having damaged layer 3 formed on backside surface 1B and epitaxial layer 2, has a warpage of, for example, not less than -150 µm and not more than 150 µm in the case where the substrate temperature is a room temperature.

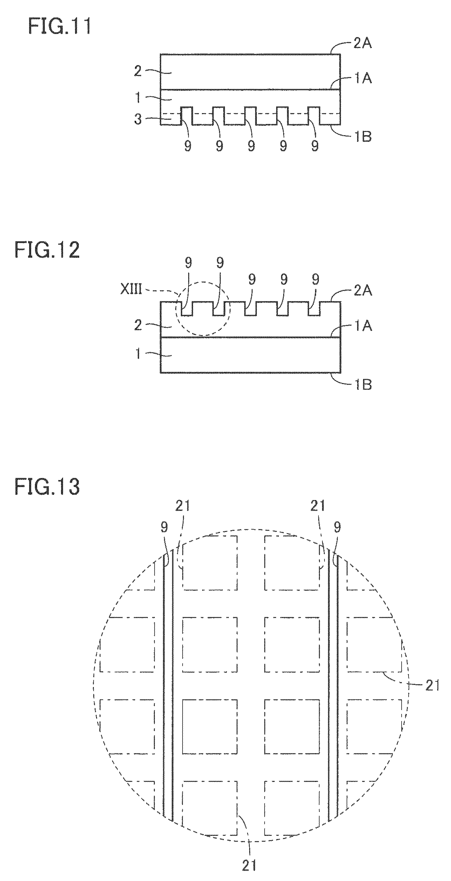

Next, with reference to Fig. 11, groove 9 is formed in backside surface 1B of base substrate 1 (step (S30)). Specifically, groove 9 is formed in backside surface 1B of base substrate 1 of stack 4 to have arbitrary depth D and width W. Groove 9 can be formed using an appropriate method such as machining or etching. Moreover, here, it is assumed that in stack 4 having been through the step (S20), main surface 2A of epitaxial layer 2 is warped in the form of a projection. In such a case, stress at the backside surface 1B side can be relaxed by forming groove 9 in backside surface 1B of base substrate 1 as described above. Accordingly, the warpage of stack 4 can be suppressed effectively.

It should be noted that when main surface 2A of epitaxial layer 2 is warped in the form of a recess after the step (S20), groove 9 may be formed in main surface 2A of epitaxial layer 2 as shown in Fig. 12. In this case, stress at the main surface 2A side of epitaxial layer 2 can be relaxed by groove 9, thereby reducing the warpage effectively. Moreover, on this occasion, it is preferable to form grooves 9 within dicing lines 21 as shown in Fig. 13 because main surface 2A of epitaxial layer 2 is a surface with which a semiconductor device is formed. In this way, no groove 9 is formed in an element formation region surrounded by the dicing lines, thereby suppressing occurrence of such a problem that the area of the element formation region becomes small due to groove 9 being formed in silicon carbide semiconductor substrate 10. Moreover, when grooves 9 are thus formed in dicing lines 21, grooves 9 may be formed only in part of the plurality of dicing lines 21 or grooves 9 may be formed in all the dicing lines 21.

Moreover, as described above, a surface to be provided with groove 9 is determined in accordance with a state of warpage of stack 4, however, both main surface 2A of epitaxial layer 2 and backside surface 1B of base substrate 1 may be provided with grooves 9 in accordance with a state of warpage

Next, the following describes function and effect of silicon carbide semiconductor substrate 10 and the method for manufacturing silicon carbide semiconductor substrate 10 according to the present embodiment. In silicon carbide semiconductor substrate 10 according to the present embodiment, groove 9 is formed in backside surface 1B of stack 4, which includes base substrate 1 having an outer diameter of 6 inches and epitaxial layer 2 formed on main surface 1A of base substrate 1, or main surface 2A of epitaxial layer 2. Accordingly, silicon carbide semiconductor substrate 10 can have a warpage of not less than -100 µm and not more than 100 µm when the substrate temperature is a room temperature, and can have an amount of warpage of not less than -1.5 mm and not more than 1.5 mm when the substrate temperature is not less than 100°C and not more than 500°C Furthermore, silicon carbide semiconductor substrate 10 also can have a warpage of not less than - 100 µm and not more than 100 µm when the substrate temperature is the room temperature, and can have an amount of warpage of not less than -1.5 mm and not more than 1.5 mm when the substrate temperature is not less than 200°C and not more than 400°C. Moreover, in the present embodiment, by appropriately adjusting and selecting the planar shape, width W and depth D of groove 9 as well as a surface to be provided with groove 9, the amount of warpage of silicon carbide semiconductor substrate 10 can be suppressed to fall within the above-described range of amount of warpage when the substrate temperature is not less than 100°C and not more than 500°C. Specifically, by appropriately adjusting the planar shape, width W and depth D of groove 9 as well as a surface to be provided with groove 9 in accordance with the shape and amount of warpage of stack 4 after the step (S20), silicon carbide semiconductor substrate 10 having a small amount of warpage under a high temperature as described above can be obtained As a result, in accordance with the method for manufacturing the silicon carbide semiconductor substrate according to the present embodiment, even when heating is performed until the substrate temperature becomes about not less than 100°C and not more than 500°C, there can be obtained silicon carbide semiconductor substrate 10 having a sufficiently small amount of warpage of not less than -1.5 mm and not more than 1.5 mm, more preferably, not less than -1.0 mm and not more than 1.0 mm.

Moreover, silicon carbide semiconductor substrate 10 produced by the method for manufacturing the silicon carbide semiconductor substrate according to the present embodiment is small in amount of warpage and has a high degree of flatness even when the outer diameter of base substrate 1 is 6 inches, the thickness of base substrate 1 is not less than 200 µm and not more than 700 µm and heating is performed at a substrate temperature of about not less than 100°C and not more than 500°C. In other words, silicon carbide semiconductor substrate 10 according to the present embodiment has a high degree of flatness under a high temperature even when base substrate 1 does not have a thickness of more than 700 µm As a result, in accordance with the method for manufacturing the silicon carbide semiconductor substrate according to the present embodiment, silicon carbide semiconductor substrate 10 having a large diameter and a high degree of flatness under a high temperature can be obtained with low cost.

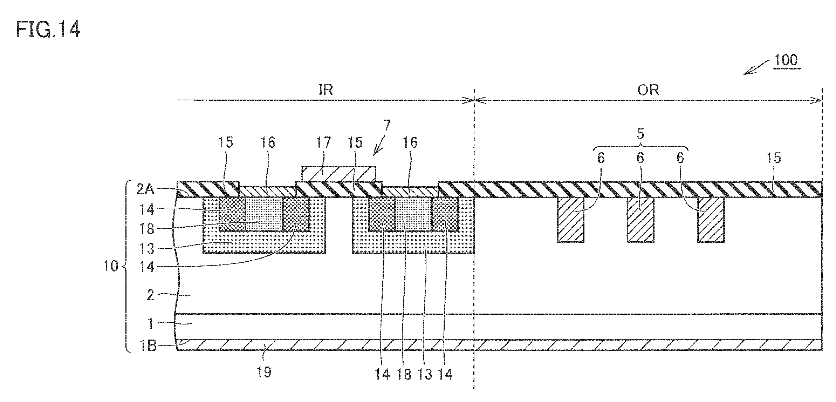

Next, with reference to Fig 14, a silicon carbide semiconductor device according to the present embodiment will be described. The silicon carbide semiconductor device according to the present embodiment includes: an element region IR (active region); and a termination region OR (inactive region) surrounding element region IR Termination region OR includes a guard ring region 5. That is, element region IR is surrounded by guard ring region 5 In element region IR, a semiconductor element 7 such as transistor or diode is provided.

Semiconductor element 7 mainly includes: silicon carbide semiconductor substrate 10 made of, for example, hexagonal silicon carbide, a gate insulating film 15, a gate electrode 17, a source electrode 16, and a drain electrode 19. Silicon carbide semiconductor substrate 10 includes base substrate 1 and epitaxial layer 2, and epitaxial layer 2 mainly includes a drift region 12, p body regions 13, n+ source regions 14, and p+ regions 18.

Drift region 12 is a region included in epitaxial layer 2 and not provided with p body region 13, n+ source region 14, and p+ region 18.

P body region 13 has p type conductivity P body region 13 is formed in drift region 12 to include main surface 2A of silicon carbide semiconductor substrate 10. P body region 13 includes a p type impurity such as aluminium (Al) or boron (B). The concentration of the impurity such as aluminum in p body region 13 is, for example, about 1 × 10¹⁷ cm⁻³.

N+ source region 14 has n type conductivity. N+ source region 14 includes main surface 2A, and is formed in p body region 13 to be surrounded by p body region 13 N+ source region 14 includes an n type impurity such as P (phosphorus), for example. The concentration of the impurity such as phosphorus in n+ source region 14 is higher than the concentration of the n type impurity in drift region 12, such as about 1 × 10²⁰ cm⁻³.

P+ region 18 has p type conductivity type. P+ region 18 is formed in contact with main surface 2A and p body region 13 so as to extend through n+ source region 14 in the vicinity of the center of n+ source region 14. P+ region 18 includes a p type impurity such as Al or B at a concentration higher than the concentration of the p type impurity included in p body region 13, such as about 1 × 10²⁰ cm⁻³.

Gate insulating film 15 is formed in contact with drift region 12 to extend from above the upper surface of one n+ source region 14 to above the upper surface of the other n+ source region 14. Gate insulating film 15 is made of, for example, silicon dioxide (SiO₂).

Gate electrode 17 is disposed on and in contact with gate insulating film 15 so as to extend from above one n+ source region 14 to above the other n+ source region 14. For example, gate electrode 17 is made of conductor such as polysilicon or Al.

In main surface 2A, source electrode 16 is provided in contact with n+ source region 14 and p+ region 18. Source electrode 16 includes titanium (Ti) atoms, Al atoms, and silicon (Si) atoms, for example. Accordingly, source electrode 16 can be in ohmic contact with both the n type silicon carbide region (n+ source region 14) and the p type silicon carbide region (p+ region 18).

Drain electrode 19 is formed in contact with backside surface 1B in silicon carbide semiconductor substrate 10. This drain electrode 19 may have the same configuration as source electrode 16, or may be made of a different material capable of ohmic contact with silicon carbide semiconductor substrate 10 (base substrate 1) such as nickel (Ni), for example. Accordingly, drain electrode 19 is electrically connected to base substrate 1.

Guard ring region 5, which has a loop-like planar shape, is provided in termination region OR of silicon carbide semiconductor substrate 10 so as to surround element region IR in which semiconductor element 7 is provided. Guard ring region 5 has p type (second conductivity type). Guard ring region 5 is an electrically conductive region serving as a guard ring.

Guard ring region 5 has a plurality of guard rings 6 each including an impurity such as boron or aluminum, for example. The concentration of the impurity in each of the plurality of guard rings 6 is lower than the concentration of the impurity in p body region 13. For example, the concentration of the impurity in each of the plurality of guard rings 6 is 1.3 × 10¹³ cm⁻³, preferably, about not less than 8 × 10¹² cm⁻³ and not more than 1.4 × 10¹³ cm⁻³, for example.

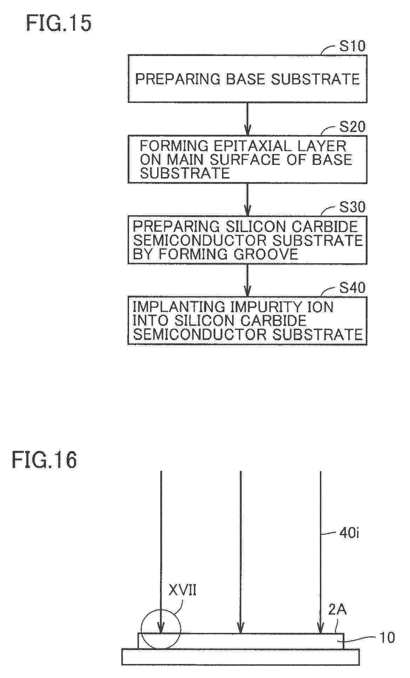

Next, with reference to Fig. 15, a method for manufacturing the silicon carbide semiconductor device according to the present embodiment will be described. In the method for manufacturing the silicon carbide semiconductor device according to the present embodiment, the silicon carbide semiconductor substrate according to the present embodiment is used for the production thereof

First, silicon carbide semiconductor substrate 10 obtained as described above is prepared (step (S10) to step (S30)). Next, with reference to Fig. 15, an impurity is implanted into main surface 2A of silicon carbide semiconductor substrate 10, thereby forming p body region 13, n source region 14, p+ region 18, and guard ring region 5 in epitaxial layer 2 (step (S40)). Specifically, for example, ions of Al are implanted as a p type impurity into epitaxial layer 2 having n type conductivity, thereby forming p body region 13 having p type conductivity. Furthermore, for example, ions of P are implanted into p body region 13 as an n type impurity, thereby forming n source region 14 having n type conductivity. Furthermore, for example, ions of Al are implanted as a p type impurity, thereby forming p+ region 18 having p type conductivity. Further, for example, ions of Al are implanted as a p type impurity, thereby forming guard ring region 5 having p type conductivity. On this occasion, the ion implantation in this step (S40) is performed with the substrate temperature of silicon carbide semiconductor substrate 10 being increased to, for example, about not less than 100°C and not more than 500°C (high-temperature implantation). At a point of time before and after performing this step (S40), silicon carbide semiconductor substrate 10 has an amount of warpage of not less than -1.5 mm and not more than 1.5 mm.

Next, heat treatment is performed to activate the impurities added by the ion implantations (step (S50)) The heat treatment is preferably performed at a temperature of not less than 1500°C and not more than 1900°C, for example, a temperature of approximately 1700°C The heat treatment is performed for approximately 30 minutes, for example. The atmosphere of the heat treatment is preferably an inert gas atmosphere, such as argon (Ar) atmosphere. At a point of time after performing this step (S50), silicon carbide semiconductor substrate 10 has an amount of warpage of not less than -1.5 mm and not more than 1.5 mm.

Next, gate insulating film 15 is formed (step (S60)). Specifically, silicon carbide semiconductor substrate 10 having the desired impurity regions formed therein is first thermally oxidized The thermal oxidation can be performed by, for example, performing heating at about 1300°C in oxygen atmosphere for about 40 minutes Accordingly, gate insulating film 15 made of SiO₂ is formed on main surface 2A of silicon carbide semiconductor substrate 10.

Next, gate electrode 17 is formed (step (S70)). In this step, for example, gate electrode 17 made of a conductor such as polysilicon or Al is formed in contact with gate insulating film 15 so as to extend from above one n+ source region 14 to above the other n+ source region 14. When polysilicon is employed as the material of gate electrode 17, the polysilicon can be configured to include P at a high concentration such as more than 1 × 10²⁰ cm⁻³ Then, an insulating film made of, for example, SiO₂ is formed to cover gate electrode 17.

Next, an ohmic electrode is formed (step (S80)). Specifically, a resist pattern is formed to have an opening to expose p+ region 18 and a portion of n+ source region 14, and a metal film including Si atoms, Ti atoms, and Al atoms is formed on the entire surface of the substrate, for example. The metal film, which is to serve as the ohmic electrode, is formed by a sputtering method or an evaporation method, for example. Then, the resist pattern is, for example, lifted off to form a metal film in contact with gate insulating film 15, p+ region 18 and n+ source region 14. Then, the metal film is heated at, for example, about 1000°C, thereby forming source electrode 16 in ohmic contact with silicon carbide semiconductor substrate 10. Moreover, drain electrode 19 is formed in ohmic contact with base substrate 1 of silicon carbide semiconductor substrate 10 In this way, silicon carbide semiconductor device 100 serving as a MOSFET is completed.

Next, the following describes function and effect of the method for manufacturing the silicon carbide semiconductor device according to the present embodiment In accordance with the method for manufacturing the silicon carbide semiconductor device according to the present embodiment, silicon carbide semiconductor substrate 10 according to the present embodiment is used in performing a process necessary for manufacturing of a silicon carbide semiconductor device, such as the ion implantation step (S40). Silicon carbide semiconductor substrate 10 has a high degree of flatness even when heat treatment is performed at a high substrate temperature of about not less than 100°C and not more than 500°C, thereby reducing a risk of causing quality defects by using a silicon carbide semiconductor substrate 10 having a large amount of warpage. For example, when silicon carbide semiconductor substrate 10 having an outer diameter of not less than 100 mm is suctioned using an electrostatic chuck stage of a semiconductor manufacturing apparatus, the amount of warpage of silicon carbide semiconductor substrate 10 is preferably not less than -1.5 mm and not more than 1.5 mm, more preferably, not less than -1.0 mm and not more than 1 0 mm in view of a risk of occurrence of defects such as occurrence of crack in silicon carbide semiconductor substrate 10 Silicon carbide semiconductor substrate 10 according to the present embodiment has an amount of warpage of not less than -1.5 mm and not more than 1.5 mm even when heat treatment is performed at a high substrate temperature of about not less than 100°C and not more than 500°C, thereby reducing the risk of causing defects such as crack in silicon carbide semiconductor substrate 10 by suctioning with an electrostatic chuck stage. Moreover, silicon carbide semiconductor substrate 10 according to the present embodiment has an amount of warpage of not less than -1.5 mm and not more than 1.5 mm even when heat treatment has been performed at a high substrate temperature of about not less than 200°C and not more than 400°C, thereby reducing the risk of causing defects such as crack in silicon carbide semiconductor substrate 10 by suctioning with an electrostatic chuck stage Further, by adjusting the planar shape and the like of groove 9, silicon carbide semiconductor substrate 10 can have an amount of warpage of not less than - 1.0 mm and not more than 1.0 mm even when heat treatment is performed at a high substrate temperature of about not less than 100°C and not more than 500°C. This further reduces the risk of causing defects such as crack in silicon carbide semiconductor substrate 10 by suctioning with an electrostatic chuck stage. Further, in silicon carbide semiconductor substrate 10 optimized in terms of the conditions such as the planar shape and the material and thickness of groove 9, the amount of warpage can be reduced to not less than -10 mm and not more than 1.0 mm even when heat treatment is performed at a high substrate temperature of about not less than 200°C and not more than 400°C. This further reduces the risk of causing defects such as crack in silicon carbide semiconductor substrate 10 by suctioning with an electrostatic chuck stage

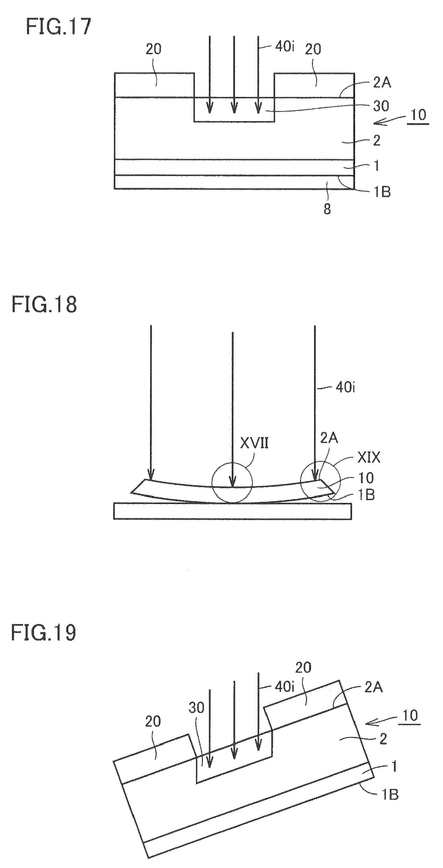

Moreover, in the method for manufacturing the silicon carbide semiconductor device according to the present embodiment, silicon carbide semiconductor substrate 10 having high degree of flatness and high parallelism of main surface 2A is employed, thereby reducing a risk associated with occurrence of defects such as variation of in-plane processing quality in main surface 2A of silicon carbide semiconductor substrate 10 Accordingly, silicon carbide semiconductor devices 100 can be produced with good yield. Specifically, with reference to Fig. 15, for example, in the step (S40), silicon carbide semiconductor substrate 10 to be subject to the step (S40) has main surface 2A having a high degree of flatness, with the result that an impurity ion implantation angle between main surface 2A and impurity implantation direction 40i (see Fig. 16) has low in-plane variation within main surface 2A. Accordingly, with reference to Fig. 17, an impurity implantation region 30 (such as p body region 13 and n source region 14) is formed uniformly at the central portion and outer circumference portion of silicon carbide semiconductor substrate 10 by implanting an impurity via the opening of mask film 20 formed on main surface 2A of silicon carbide semiconductor substrate 10. From a different point of view, in silicon carbide semiconductor device 100, impurity implantation region 30 has a side wall portion extending in a direction perpendicular to main surface 2A.

On the other hand, with reference to Fig. 18, in the ion implantation step, if silicon carbide semiconductor substrate 10 has a large amount of warpage and main surface 2A has a low degree of flatness, the ion implantation angle between main surface 2A and impurity implantation direction 40i has large in-plane variation within main surface 2A. In this case, with reference to Fig. 19, impurity implantation region 30 (such as p body region 13 and n source region 14) is varied between the central portion and the outer circumference portion of silicon carbide semiconductor substrate 10 in terms of the position or manner of expansion of the region formed in silicon carbide semiconductor substrate 10. From a different point of view, in silicon carbide semiconductor device 100, impurity implantation region 30 is locally varied in main surface 2A in terms of a direction of extension of the side wall portion with respect to main surface 2A That is, in accordance with the method for manufacturing the silicon carbide semiconductor device according to the present embodiment, even when large-diameter silicon carbide semiconductor substrate 10 having an outer diameter of not less than 100 mm is used, impurity implantation region 30 can be formed in the entire main surface 2A of silicon carbide semiconductor substrate 10 to have a side wall portion extending perpendicularly to main surface 2A. Accordingly, such a problem never arises that the shape of impurity implantation region 30 (for example, the direction in which the side wall portion extends) differs locally in main surface 2A, thereby obtaining silicon carbide semiconductor device 100 with good yield.

It should be noted that the silicon carbide semiconductor device according to the present embodiment may have a field stop region (not shown) to surround guard ring region 5. The field stop region may be formed in the impurity implantation step (S40) to have n type conductivity, by means of high-temperature implantation in the same manner as that for source region 14 and the like. The silicon carbide semiconductor device according to the present embodiment is produced using silicon carbide semiconductor substrate 10 having a high degree of flatness even under high temperature environment, thereby suppressing occurrence of a problem such as guard ring region 5 or the field stop region being varied locally in main surface 2A in terms of position and configuration Specifically, it is possible to suppress variation of a space between guard ring region 5 and the field stop region in main surface 2A, for example.

Although the embodiment of the present invention has been illustrated as described above, the embodiment can be modified in various manners. Moreover, the scope of the present invention is not limited by the embodiment described above. The scope of the present invention is defined by the terms of the claims, and is intended to include any modifications within the scope and meaning equivalent to the terms of the claims

### INDUSTRIAL APPLICABILITY

The present invention is particularly advantageously applied to a large-diameter silicon carbide semiconductor substrate having an outer diameter of not less than 100 mm, a method for manufacturing the silicon carbide semiconductor substrate, and a method for manufacturing a silicon carbide semiconductor device using the silicon carbide semiconductor substrate.

### REFERENCE SIGNS LIST

1: base substrate; 1A, 2A: main surface; 1B: backside surface; 2: epitaxial layer; 3: damaged layer; 4 stack; 5: guard ring region; 6: guard ring; 7: semiconductor element; 9: groove; 10: silicon carbide semiconductor substrate; 12: drift region; 13: body region; 14: source region; 15: gate insulating film; 16: source electrode, 17: gate electrode; 18: p+ region; 19: drain electrode; 20: mask film; 21: dicing line; 30: impurity implantation region; 100: silicon carbide semiconductor device

## Claims

1. A silicon carbide semiconductor substrate comprising:
a base substrate that has a main surface having an outer diameter of not less than 100 mm and that is made of single-crystal silicon carbide; and
an epitaxial layer formed on said main surface,
a groove being formed in at least one of a main surface of said epitaxial layer and a backside surface of said base substrate, said main surface of said epitaxial layer being opposite to a surface of said epitaxial layer facing said base substrate, said backside surface of said base substrate being opposite to said main surface of said base substrate on which said epitaxial layer is formed

2. The silicon carbide semiconductor substrate according to claim 1, wherein said silicon carbide semiconductor substrate has an amount of warpage of not less than -100 µm and not more than 100 µm when a substrate temperature is a room temperature, and has an amount of warpage of not less than -1.5 mm and not more than 1.5 mm when the substrate temperature is 400°C.

3. The silicon carbide semiconductor substrate according to claim 1 or claim 2, wherein said groove has any one planar shape selected from a group consisting of a form of stripes, a form of grid, a form of concentric circles, and a form of honeycomb.

4. A method for manufacturing a silicon carbide semiconductor substrate, comprising steps of
preparing a base substrate that has a main surface having an outer diameter of not less than 100 mm and that is made of single-crystal silicon carbide;
forming an epitaxial layer on said main surface; and
forming a groove in at least one of a main surface of said epitaxial layer and a backside surface of said base substrate, said main surface of said epitaxial layer being opposite to a surface of said epitaxial layer facing said base substrate, said backside surface of said base substrate being opposite to said main surface of said base substrate on which said epitaxial layer is formed

5. The method for manufacturing the silicon carbide semiconductor substrate according to claim 4, wherein in the step of forming said groove, said groove is formed in said main surface of said epitaxial layer when said main surface of said epitaxial layer is warped in a form of recess after the step of forming said epitaxial layer, and said groove is formed in said backside surface when said main surface of said epitaxial layer is warped in a form of projection after the step of forming said epitaxial layer

6. A method for manufacturing a silicon carbide semiconductor device, comprising steps of:
preparing a base substrate that has a main surface having an outer diameter of not less than 100 mm and that is made of single-crystal silicon carbide;
forming an epitaxial layer on said main surface;
preparing a silicon carbide semiconductor substrate by forming a groove in at least one of a main surface of said epitaxial layer and a backside surface of said base substrate, said main surface of said epitaxial layer being opposite to a surface of said epitaxial layer facing said base substrate, said backside surface of said base substrate being opposite to said main surface of said base substrate on which said epitaxial layer is formed; and
implanting an impurity ion into said silicon carbide semiconductor substrate.
